# EUROPEAN PATENT APPLICATION

(11) **EP 4 808 309 A1**
(43) Date of publication of application: **16.09.2026**
(21) Application number: 26158919.6
(22) Date of filing: 17.02.2026
(51) Int. Cl.: H10D 86/40, H10D 1/68, H10D 86/60, H10K 59/121, H01G 4/33

(54) **DISPLAY DEVICE, METHOD OF MANUFACTURING THE SAME AND ELECTRONIC DEVICE INCLUDING THE DISPLAY DEVICE**

(30) Priority: 12.03.2025 KR 20250031939
(71) Applicant: Samsung Display Co., Ltd., Yongin-si, Gyeonggi-do 17113 (KR)
(72) Inventor: Yang, Sukyoung, 17113 Yongin-si, Gyeonggi-do (KR); Song, Dokeun, 17113 Yongin-si, Gyeonggi-do (KR); Lee, Kyong-Chol, 17113 Yongin-si, Gyeonggi-do (KR); Jeong, Samtae, 17113 Yongin-si, Gyeonggi-do (KR)
(74) Representative: Gulde & Partner

(57) **Abstract**

A display device (DD) includes a transistor (T1), a capacitor (C1) electrically connected to the transistor (T1) and including a first capacitor electrode (CPE1) including a first conductive layer (ML1) and a plasma-treated layer (PTL) disposed on the first conductive layer (ML1) and a second capacitor electrode (CPE2) disposed on the first capacitor electrode (CPE1) and including a second conductive layer (ML2), and an insulating layer (IL2) disposed between the first capacitor electrode (CPE1) and the second capacitor electrode (CPE2).

## Description

### BACKGROUND

### 1. FIELD

Embodiments relate to a display device, a method of manufacturing the display device, and an electronic device including the display device.

### 2. DESCRIPTION OF THE RELATED ART

A display device displays an image to provide visual information to a user. The display device may be operated by thin film transistors, capacitors, and a plurality of lines that are interconnected in a complex manner.

Recently, as demand for compact and high-resolution display devices increases, there is a growing desire for efficient spatial arrangement, connection structures, and driving methods among the thin film transistors, the capacitors, and the lines included in the display device, as well as improving quality of displayed images.

### SUMMARY

Embodiments provide a display device including a capacitor with improved capacitance characteristics.

Embodiments provide a method of manufacturing the display device.

Embodiments provide an electronic device including the display device.

A display device in an embodiment of the disclosure includes a transistor, a capacitor electrically connected to the transistor and including a first capacitor electrode including a first conductive layer and a plasma-treated layer disposed on the first conductive layer and a second capacitor electrode disposed on the first capacitor electrode and including a second conductive layer, and an insulating layer disposed between the first capacitor electrode and the second capacitor electrode.

In an embodiment, the plasma-treated layer may be disposed between the first conductive layer and the second conductive layer, and a dielectric constant of the plasma-treated layer may be greater than a dielectric constant of the insulating layer.

In an embodiment, the plasma-treated layer may include a high-k material. In an embodiment, the high-k material may refer to a dielectric material having a dielectric constant higher than that of silicon oxide (SiOx) or silicon nitride (SiNx).

In an embodiment, the second capacitor electrode may be disposed directly on the insulating layer.

In an embodiment, the dielectric constant of the plasma-treated layer may be about 2 to about 50 times greater than a dielectric constant of the insulating layer.

In an embodiment, the dielectric constant of the plasma-treated layer may be about 5 to about 45 times greater than a dielectric constant of the insulating layer.

In an embodiment, the dielectric constant of the plasma-treated layer may be about 10 to about 40 times greater than a dielectric constant of the insulating layer.

In an embodiment, the plasma-treated layer may directly contact the first conductive layer and/or the insulating layer. The plasma-treated layer may be disposed directly on the first conductive layer. The direct contact of the plasma-treated layer with the respective layer simplifies a manufacturing process by eliminating intermediate layers and improves electrical performance. Specifically, it prevents an additional layer with a lower dielectric constant from reducing the overall capacitance of the capacitor, thereby maximizing the beneficial effect of the high-k layer.

In an embodiment, the insulating layer may cover the first capacitor electrode (partially or entirely).

In an embodiment, the plasma-treated layer may cover an upper surface of the first conductive layer.

In an embodiment, the plasma-treated layer may completely cover the upper surface of the first conductive layer. By completely covering the upper surface of the first conductive layer, the plasma-treated layer creates a uniform insulating barrier. This effectively prevents electrical short circuits and leakage currents to an overlying conductive layer and ensures that the capacitance is uniform across the entire area, which is crucial for stable and reliable pixel performance.

In an embodiment, the plasma-treated layer may include an inorganic insulating material.

In an embodiment, the plasma-treated layer may include titanium oxide.

In an embodiment, the plasma-treated layer may cover a side surface and/or an upper surface of the first conductive layer. In other words, the plasma-treated layer may overlap an upper surface of the first conductive layer and extend along a side surface of the first conductive layer. The plasma-treated layer may cover only the side surface, only the upper surface or both surfaces. This embodiment allows for an increase in the total capacitance by utilizing not only the planar area (upper surface) but also the vertical side surfaces of the conductive layer for capacitive coupling. This increases the effective capacitor area without increasing the space required in the pixel plane, leading to a higher capacitance density and improved device performance.

In an embodiment, the first capacitor electrode and/or the second capacitor electrode may have a multilayer structure in which a plurality of layers are stacked.

In an embodiment, the first conductive layer may include a first sub-conductive layer, a second sub-conductive layer (e. g. directly) disposed on (e. g. an upper surface of) the first sub-conductive layer and a third sub-conductive layer (e. g. directly) disposed on (e. g. an upper surface of) the second sub-conductive layer. The first, second, and third sub-conductive layers may include the same material, or at least one of the first, second, and third sub-conductive layers may include a different material.

In an embodiment, the plasma-treated layer may be disposed (directly) on (an upper surface of) the third sub-conductive layer.

In an embodiment, the plasma-treated layer may substantially cover the entirety of the upper surface of the third sub-conductive layer.

In an embodiment, each of the first sub-conductive layer and the third sub-conductive layer may include titanium (Ti), and the second sub-conductive layer may include aluminum (Al).

In an embodiment, the first conductive layer may include a first sub-conductive layer, a second sub-conductive layer disposed on the first sub-conductive layer and including a material different from a material of the first sub-conductive layer, and a third sub-conductive layer disposed on the second sub-conductive layer and including a material different from the material of the second sub-conductive layer, and the plasma-treated layer may include a first sub-plasma-treated layer covering (e. g. only) a side surface of the first sub-conductive layer, a second sub-plasma-treated layer covering (e. g. only) a side surface of the second sub-conductive layer, and a third sub-plasma-treated layer covering a side surface of the third sub-conductive layer and an upper surface of the third sub-conductive layer. Each covering may refer to the entirety of the respective side surface.

In an embodiment, each of the first sub-plasma-treated layer and the third sub-plasma-treated layer may include titanium oxide, and the second sub-plasma-treated layer may include aluminum oxide. This laminate structure leverages the high dielectric constant of the titanium oxide layers to increase capacitance, while the central aluminum oxide layer serves as a robust insulating barrier to effectively suppress leakage current. The result is a composite dielectric that simultaneously achieves a high capacitance density and excellent electrical reliability.

In an embodiment, a thickness of the plasma-treated layer along a thickness direction may be in a range of about 50 angstroms (Å) to about 700 Å. The specified thickness range represents an advantageous trade-off. A thickness below 50 Å risks high leakage current and electrical defects, while a thickness above 700 Å would unnecessarily decrease the capacitance, thereby diminishing the benefit of the high-k material. This range thus ensures both high capacitance and robust electrical reliability.

The thickness direction may refer to the direction perpendicular to a main plane of extension of the layers or the display device. The thickness direction may extend along a third direction referred to in the figures.

In an embodiment, a thickness of the plasma-treated layer along a thickness direction may be in a range of about 100 angstroms (Å) to about 600 Å.

In an embodiment, a thickness of the plasma-treated layer along a thickness direction may be in a range of about 150 angstroms (Å) to about 500 Å.

In an embodiment, a dielectric constant (or permittivity) of the plasma-treated layer may be in a range of about 10 to about 100.

In an embodiment, a dielectric constant of the plasma-treated layer may be in a range of about 20 to about 90.

In an embodiment, a dielectric constant of the plasma-treated layer may be in a range of about 40 to about 80.

In an embodiment, the plasma-treated layer may be an insulating layer.

A method of manufacturing a display device in an embodiment of the disclosure includes forming a first capacitor electrode including a first conductive layer and a plasma-treated layer disposed on the first conductive layer, forming an insulating layer on the first capacitor electrode, forming a second capacitor electrode on the insulating layer, the second capacitor electrode including a second conductive layer and defining a capacitor with the first capacitor electrode, and forming a transistor electrically connected to the capacitor.

The method of manufacturing the display device may therefore be a method for manufacturing the display device according to an embodiment described above. Accordingly, the method or rather the manufactured display device may include the features described in connection with the embodiments of the display device and the associated advantages.

In an embodiment, the first conductive layer may include a first sub-conductive layer, a second sub-conductive layer (e. g. directly) disposed on (e. g. an upper surface of) the first sub-conductive layer and a third sub-conductive layer (e. g. directly) disposed on (e. g. an upper surface of) the second sub-conductive layer.

In an embodiment, a preliminary first conductive layer may be formed, e. g. on another insulating layer. The preliminary first conductive layer may have a multilayer structure in which a plurality of layers are stacked. The preliminary first conductive layer may include a preliminary first sub-conductive layer, a preliminary second sub-conductive layer (e. g. on an upper surface of the preliminary first sub-conductive layer), and a preliminary third sub-conductive layer (e. g. on an upper surface of the preliminary second sub-conductive layer). The preliminary first sub-conductive layer, the preliminary second sub-conductive layer and the preliminary third sub-conductive layer may be formed through a sputtering process.

In an embodiment, in the forming the first capacitor electrode, the plasma-treated layer may be formed by oxidizing at least a portion (e. g. an upper surface) of a preliminary first conductive layer by treating the preliminary first conductive layer (i.e., an upper surface of the preliminary third sub-conductive layer) with oxygen plasma. That is, the plasma-treated layer may be different from an oxide film (i.e., a naturally oxidized film) that may be formed by naturally oxidizing the first conductive layer.

In an embodiment, a minimum value of a thickness of the plasma-treated layer may be a thickness of an oxide film that may be formed by naturally oxidizing the upper surface of the third sub-conductive layer and a maximum value of the thickness of the plasma-treated layer may be a thickness of the third sub-conductive layer before the plasma-treated layer is formed.

In an embodiment, the plasma-treated layer may be disposed between the first conductive layer and the second conductive layer, and a dielectric constant of the plasma-treated layer may be greater than a dielectric constant of the insulating layer.

In an embodiment, the forming the first capacitor electrode may include forming a preliminary first conductive layer, plasma-treating an upper surface of the preliminary first conductive layer (i.e., an upper surface of the preliminary first conductive layer or of the preliminary third sub-conductive layer) to form a preliminary plasma-treated layer, and patterning the preliminary first conductive layer and the preliminary plasma-treated layer to form the first conductive layer and the plasma-treated layer. In other words, the plasma-treated layer is formed before patterning.

In an embodiment, when the preliminary first conductive layer includes the preliminary first sub-conductive layer, the preliminary second sub-conductive layer and preliminary the third sub-conductive layer the first capacitor electrode including the first, second, and third sub-conductive layers and the plasma-treated layer may be formed by patterning the preliminary first, second and third sub-conductive layers.

In an embodiment, the plasma-treated layer may cover an upper surface of the first conductive layer.

In an embodiment, the plasma-treated layer may include titanium oxide.

In an embodiment, the forming the first capacitor electrode may include forming a preliminary first conductive layer, patterning the preliminary first conductive layer, and plasma-treating a side surface and an upper surface of the preliminary first conductive layer to form the first conductive layer and the plasma-treated layer. In other words, the plasma-treated layer is formed after patterning.

In an embodiment, the plasma-treated layer may include a first sub-plasma-treated layer covering a side surface of the first conductive layer and a second sub-plasma-treated layer covering an upper surface of the first conductive layer and including a material different from a material of the first sub-plasma-treated layer.

In an embodiment, (after patterning) a side surface of the preliminary first sub-conductive layer may be plasma-treated, and the plasma-treated layer may be formed on the side surface of the preliminary first sub-conductive layer, so that the first sub-conductive layer and the first sub-plasma-treated layer covering the side surface of the first sub-conductive layer may be formed. A side surface of the preliminary second sub-conductive layer may be plasma-treated, and the plasma-treated layer may be formed on the side surface of the preliminary second sub-conductive layer, so that the second sub-conductive layer and the second sub-plasma-treated layer covering the side surface of the second sub-conductive layer may be formed. A side surface and an upper surface of the preliminary third sub-conductive layer may be plasma-treated, and the plasma-treated layer may be formed on the side surface and the upper surface of the preliminary third sub-conductive layer, so that the third sub-conductive layer and the third sub-plasma-treated layer covering the side surface and the upper surface of the third sub-conductive layer may be formed.

In an embodiment, the plasma-treating may be an oxygen plasma process.

In an embodiment, the first sub-plasma-treated layer may include aluminum oxide, and the second sub-plasma-treated layer may include titanium oxide.

An electronic device in an embodiment of the disclosure includes a display device and a processor that provides a control signal and input image data to the display device. The display device includes a transistor, a capacitor electrically connected to the transistor and including a first capacitor electrode including a first conductive layer and a plasma-treated layer disposed on the first conductive layer and a second capacitor electrode disposed on the first capacitor electrode and including a second conductive layer, and an insulating layer disposed between the first capacitor electrode and the second capacitor electrode.

The electronic device in an embodiment may therefore include the display device according to an embodiment described above. Accordingly, the electronic device may include the features described in connection with the embodiments of the display device and the associated advantages.

Although an increase in a capacitance of a capacitor is desired, difficulties may arise since enlarging the area of the capacitor is restricted due to pixel integration constraints, and it is also difficult to increase the capacitance by reducing a thickness of an insulating layer between capacitor electrodes due to leakage current concerns.

In a display device in embodiments of the disclosure, the display device may include a capacitor defined by a first capacitor electrode including a plasma-treated layer and a second capacitor electrode. As the plasma-treated layer includes a high dielectric constant (or high-k) material, a capacitance of the capacitor may be secured even without increasing an area of the capacitor or without reducing a thickness of the second insulating layer. Accordingly, the display device including the capacitor with improved capacitance characteristics may be implemented.

### BRIEF DESCRIPTION OF THE DRAWINGS

The above and other embodiments, advantages and features of this disclosure will become more apparent by describing in further detail embodiments thereof with reference to the accompanying drawings, in which:
FIG. 1 is a plan view illustrating an embodiment of a display device according to the disclosure.
FIG. 2 is a block diagram illustrating the display device of FIG. 1.
FIG. 3 is a circuit diagram illustrating an embodiment of a pixel included in the display device of FIG. 1.
FIG. 4 is a cross-sectional view illustrating an embodiment of a display panel included in the display device of FIG. 1.
FIG. 5 is an enlarged cross-sectional view of area A in FIG. 4.
FIGS. 6, 7, and 8 are cross-sectional views illustrating an embodiment of a method of manufacturing a display device according to the disclosure.
FIG. 9 is a cross-sectional view illustrating an embodiment of a display device according to the disclosure.
FIGS. 10, 11, and 12 are cross-sectional views illustrating an embodiment of a method of manufacturing a display device according to the disclosure.
FIG. 13 is a block diagram illustrating an embodiment of an electronic device according to the disclosure.
FIG. 14 is a schematic view illustrating an embodiment of electronic devices according to the disclosure.

### DETAILED DESCRIPTION

Hereinafter, embodiments of the disclosure will be described in more detail with reference to the accompanying drawings. The same reference numerals are used for the same components in the drawings, and redundant descriptions of the same components will be omitted.

It will be understood that when an element is referred to as being "on" another element, it may be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," may therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" may, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term such as "about" may mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

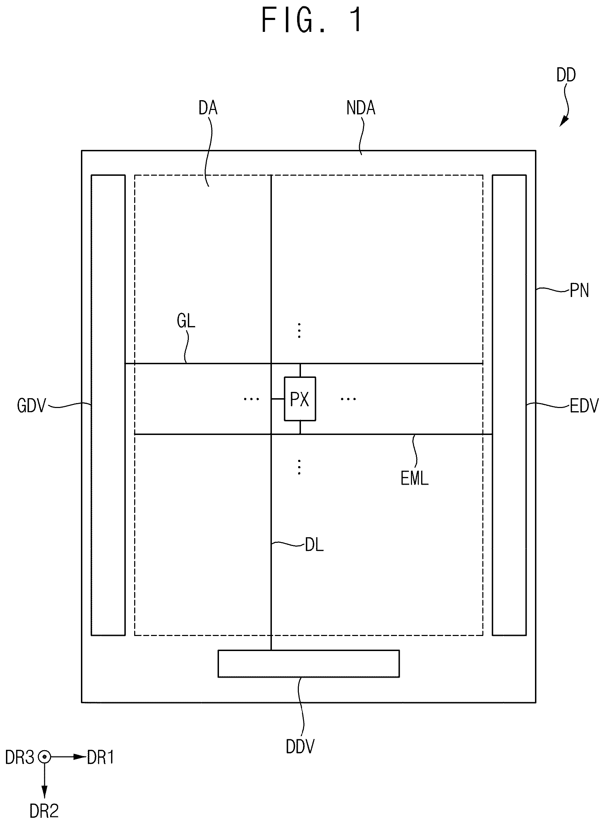

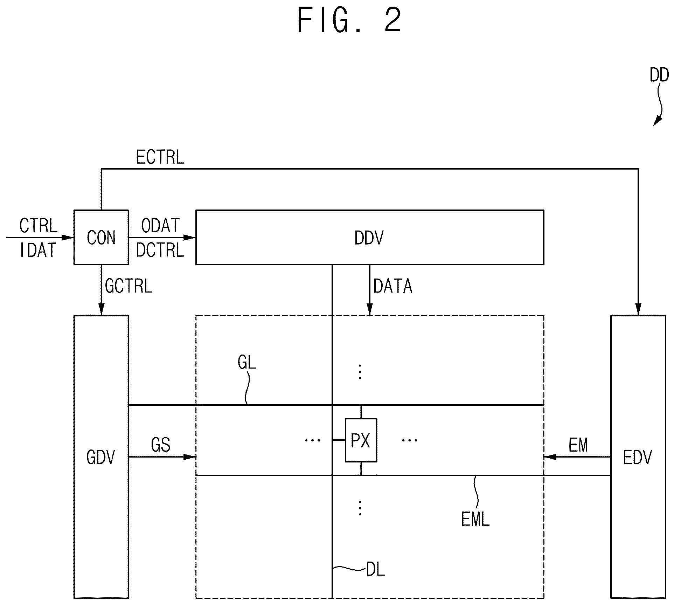

FIG. 1 is a plan view illustrating an embodiment of a display device according to the disclosure. FIG. 2 is a block diagram illustrating the display device of FIG. 1.

Referring to FIGS. 1 and 2, a display device DD may include a display panel PN and a driver that drives the display panel PN. The display panel PN may include a display area DA and a non-display area NDA.

The display area DA may be an area that displays an image. A plurality of pixels PX may be disposed in the display area DA. In an embodiment, the pixels PX may be repeatedly arranged along a first direction DR1 and a second direction DR2 intersecting the first direction DR1, for example. As each of the pixels PX emits light, the display area DA may display an image. In an embodiment, the display area DA may display an image in a third direction DR3 intersecting each of the first direction DR1 and the second direction DR2, for example.

The non-display area NDA may be an area that does not display an image. The non-display area NDA may be disposed around the display area DA. In an embodiment, the non-display area NDA may surround the display area DA in a plan view, for example. The driver may be disposed in the non-display area NDA. In an embodiment, the driver may provide signals and/or voltages to the pixels PX, for example. In an embodiment, the driver may include a gate driver GDV, a light-emitting driver EDV, a data driver DDV, and a controller CON, for example.

Each of the pixels PX may be electrically connected to the gate driver GDV, the light-emitting driver EDV, and the data driver DDV. Each of the pixels PX may be electrically connected to the gate driver GDV through a gate line GL, may be electrically connected to the light-emitting driver EDV through a light-emitting line EML, and may be electrically connected to the data driver DDV through a data line DL. Accordingly, each of the pixels PX may receive a gate signal GS, a light-emitting signal EM, and a data voltage DATA.

The gate driver GDV may receive a gate control signal GCTRL from the controller CON. The gate driver GDV may generate the gate signal GS based on the gate control signal GCTRL. The gate signal GS may be supplied to each of the pixels PX through the gate line GL.

The light-emitting driver EDV may receive a light-emitting control signal ECTRL from the controller CON. The light-emitting driver EDV may generate the light-emitting signal EM based on the light-emitting control signal ECTRL. The light-emitting signal EM may be supplied to each of the pixels PX through the light-emitting line EML.

The data driver DDV may receive a data control signal DCTRL and output image data ODAT from the controller CON. The data driver DDV may generate the data voltage DATA based on the data control signal DCTRL and the output image data ODAT. The data voltage DATA may be supplied to each of the pixels PX through the data line DL.

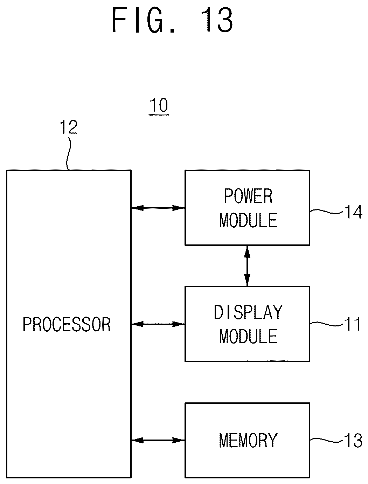

The controller CON may receive a control signal CTRL and input image data IDAT from an external device (e.g., a processor 12 of FIG. 13). The controller CON may generate the gate control signal GCTRL, the light-emitting control signal ECTRL, the data control signal DCTRL, and the output image data ODAT based on the control signal CTRL and the input image data IDAT. The controller CON may control the gate driver GDV, the light-emitting driver EDV, and the data driver DDV.

Although FIG. 1 illustrates that the gate driver GDV is disposed on a first side of the display device DD, and the light-emitting driver EDV is disposed on a second side of the display device DD, the disclosure is not limited thereto. In an embodiment, the gate driver GDV and the light-emitting driver EDV may be disposed together on the first side or the second side of the display device DD, for example. In another embodiment, the gate driver GDV and the light-emitting driver EDV may be integrally formed (or unitary).

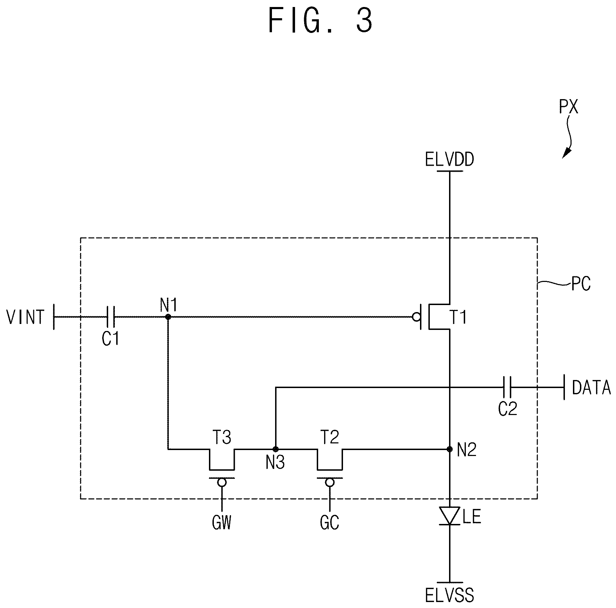

FIG. 3 is a circuit diagram illustrating an embodiment of a pixel included in the display device of FIG. 1.

Referring to FIG. 3, each of the pixels PX may include a pixel circuit PC and a light-emitting element LE. The pixel circuit PC may include at least one thin film transistor and at least one capacitor. In an embodiment, the pixel circuit PC may include a first transistor T1, a second transistor T2, a third transistor T3, a first capacitor C1, and a second capacitor C2.

The first transistor T1 may include a gate electrode connected to a first node N1, a first electrode to which a first power supply voltage ELVDD is applied, and a second electrode connected to a second node N2. The first transistor T1 may generate a driving current applied to the light-emitting element LE according to a voltage of the gate electrode of the first transistor T1 (i.e., the first node N1). In an embodiment, the first transistor T1 may be also referred to as a driving transistor, for example.

The second transistor T2 may include a gate electrode to which a compensation gate signal GC is applied, a first electrode connected to a third node N3, and a second electrode connected to the second node N2. In an embodiment, the second transistor T2 may be also referred to as a compensation transistor, for example.

The third transistor T3 may include a gate electrode to which a write gate signal GW is applied, a first electrode connected to the first node N1, and a second electrode connected to the third node N3. In an embodiment, the third transistor T3 may be also referred to as a write transistor, for example.

The first capacitor C1 may include a first electrode to which an initialization voltage VINT is applied and a second electrode connected to the first node N1. In an embodiment, the first capacitor C1 may be also referred to as a storage capacitor, for example.

The second capacitor C2 may include a first electrode connected to the third node N3 and a second electrode to which a data voltage DATA is applied. In an embodiment, the second capacitor C2 may be also referred to as a programming capacitor, for example.

The light-emitting element LE may include a first electrode connected to the second node N2 and a second electrode to which a second power supply voltage ELVSS is applied. In an embodiment, the second power supply voltage ELVSS may be a voltage having a lower level than the first power supply voltage ELVDD, for example. The light-emitting element LE may emit light based on the driving current generated by the first transistor T1.

Although FIG. 3 illustrates that each of the pixels PX includes three transistors, two capacitors, and one light-emitting element, this is merely illustrative and the disclosure is not limited thereto. In an embodiment, each of the pixels PX may include one or more transistors, one or more capacitors, and one or more light-emitting elements, for example.

In addition, although FIG. 3 illustrates that each of the first, second, and third transistors T1, T2, and T3 is a p-type transistor (e.g., a p-channel metal-oxide-semiconductor ("PMOS") transistor), this is merely illustrative and the disclosure is not limited thereto. In an embodiment, at least one of the first, second, and third transistors T1, T2, and T3 may be an n-type transistor (e.g., an n-channel metal-oxide-semiconductor ("NMOS") transistor), for example.

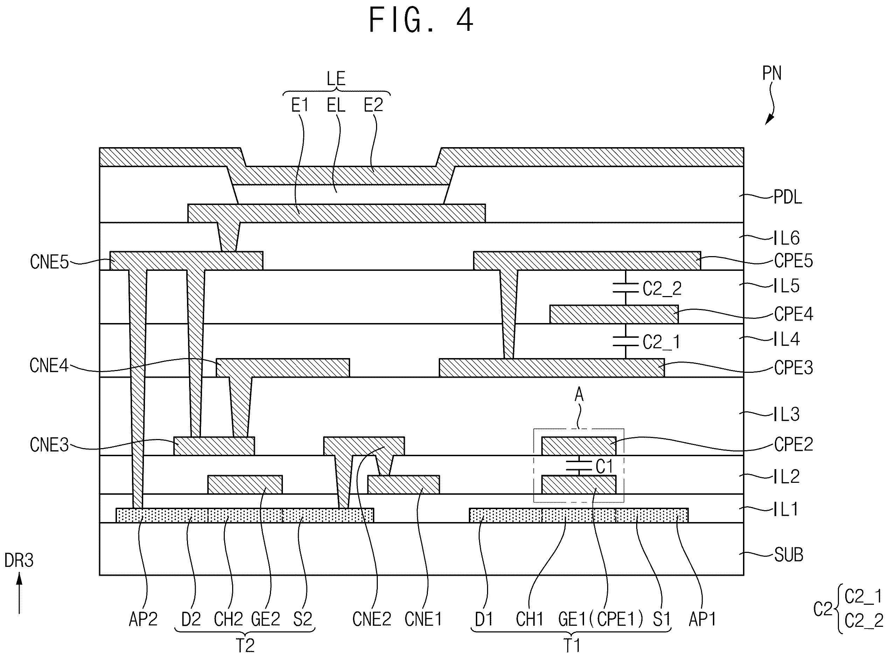

FIG. 4 is a cross-sectional view illustrating an embodiment of a display panel included in the display device of FIG. 1.

Referring to FIG. 4, the display panel PN may include a substrate SUB, at least one semiconductor layer, a plurality of conductive layers, a plurality of insulating layers, and the light-emitting element LE.

The display panel PN may include a first active pattern AP1, a second active pattern AP2, a first insulating layer IL1, a first gate electrode GE1 (or a first capacitor electrode CPE1), a second gate electrode GE2, a first connection electrode CNE1, a second insulating layer IL2, a second capacitor electrode CPE2, a second connection electrode CNE2, a third connection electrode CNE3, a third insulating layer IL3, a third capacitor electrode CPE3, a fourth connection electrode CNE4, a fourth insulating layer IL4, a fourth capacitor electrode CPE4, a fifth insulating layer IL5, a fifth capacitor electrode CPE5, a fifth connection electrode CNE5, a sixth insulating layer IL6, a first electrode E1, a pixel defining layer PDL, a light-emitting layer EL, and a second electrode E2.

The substrate SUB may include a transparent or opaque material. The substrate SUB may include glass, quartz, plastic, or the like. These may be used alone or in combination.

The first active pattern AP1 and the second active pattern AP2 may be disposed on the substrate SUB. The first and second active patterns AP1 and AP2 may include a silicon semiconductor material or an oxide semiconductor material. In embodiments, the silicon semiconductor material may include amorphous silicon, polycrystalline silicon, or the like. In embodiments, the oxide semiconductor material may include indium gallium zinc oxide ("IGZO"), indium tin zinc oxide ("ITZO"), or the like. These may be used alone or in combination.

The first active pattern AP1 may include a first source area S1, a first drain area D1, and a first channel area CH1 between the first source area S1 and the first drain area D1. The first active pattern AP1 may exhibit different electrical properties depending on whether it is doped. In an embodiment, the first source area S1 and the first drain area D1 may be areas doped with a p-type impurity or an n-type impurity, for example. In an embodiment, the first source area S1 may be the first electrode of the first transistor T1, the first drain area D1 may be the second electrode of the first transistor T1, and the first channel area CH1 may be a channel of the first transistor T1, for example.

The second active pattern AP2 may include a second source area S2, a second drain area D2, and a second channel area CH2 between the second source area S2 and the second drain area D2. The second active pattern AP2 may exhibit different electrical properties depending on whether it is doped. In an embodiment, the second source area S2 and the second drain area D2 may be areas doped with a p-type impurity or an n-type impurity, for example. In an embodiment, the second source area S2 may be the first electrode of the second transistor T2, the second drain area D2 may be the second electrode of the second transistor T2, and the second channel area CH2 may be a channel of the second transistor T2, for example.

The first insulating layer IL1 may be disposed on the first and second active patterns AP1 and AP2, and may cover the first and second active patterns AP1 and AP2. The first insulating layer IL1 may include an inorganic insulating material such as silicon oxide (SiOₓ), silicon nitride (SiNₓ), silicon oxynitride (SiOₓN_{y}), or the like. The first insulating layer IL1 may have a single-layer structure or a multilayer structure including a plurality of insulating layers.

The first gate electrode GE1, the second gate electrode GE2, and the first connection electrode CNE1 may be disposed on the first insulating layer IL1. The first gate electrode GE1 may be also referred to as the first capacitor electrode CPE1. The first and second gate electrodes GE1 and GE2 and the first connection electrode CNE1 may include a conductive material such as metal, alloy, conductive metal oxide, conductive metal nitride, transparent conductive material, or the like. Each of the first and second gate electrodes GE1 and GE2 and the first connection electrode CNE1 may have a single-layer structure or a multilayer structure including a plurality of conductive layers.

The first gate electrode GE1 may at least partially overlap the first active pattern AP1 in a plan view. At least a portion of the first gate electrode GE1 may overlap the first channel area CH1 of the first active pattern AP1 in a plan view. The portion of the first gate electrode GE1 overlapping the first channel area CH1 in a plan view may be the gate electrode of the first transistor T1.

The second gate electrode GE2 may at least partially overlap the second active pattern AP2 in a plan view. At least a portion of the second gate electrode GE2 may overlap the second channel area CH2 of the second active pattern AP2 in a plan view. The portion of the second gate electrode GE2 overlapping the second channel area CH2 in a plan view may be the gate electrode of the second transistor T2.

The second insulating layer IL2 may be disposed on the first and second gate electrodes GE1 and GE2 and the first connection electrode CNE1, and may cover the first and second gate electrodes GE1 and GE2 and the first connection electrode CNE1. The second insulating layer IL2 may include an inorganic insulating material. The second insulating layer IL2 may have a single-layer structure or a multilayer structure including a plurality of insulating layers.

The second capacitor electrode CPE2, the second connection electrode CNE2, and the third connection electrode CNE3 may be disposed on the second insulating layer IL2. The second capacitor electrode CPE2 and the second and third connection electrodes CNE2 and CNE3 may include a conductive material. Each of the second capacitor electrode CPE2 and the second and third connection electrodes CNE2 and CNE3 may have a single-layer structure or a multilayer structure including a plurality of conductive layers.

The second capacitor electrode CPE2 may at least partially overlap the first capacitor electrode CPE1 in a plan view. At least a portion of the second capacitor electrode CPE2 may overlap the first capacitor electrode CPE1 in a plan view. In an embodiment, the first capacitor electrode CPE1 and the portion of the second capacitor electrode CPE2 overlapping the first capacitor electrode CPE1 in a plan view may define the first capacitor C1. In an embodiment, the first capacitor electrode CPE1 may be the second electrode of the first capacitor C1, and the second capacitor electrode CPE2 may be the first electrode of the first capacitor C1, for example. In an embodiment, the initialization voltage VINT of FIG. 3 may be applied to the second capacitor electrode CPE2, for example.

The second connection electrode CNE2 may be connected to the second source area S2 of the second active pattern AP2 through a contact hole penetrating a lower insulating layer (e.g., the first and second insulating layers IL1 and IL2). In addition, the second connection electrode CNE2 may be connected to the first connection electrode CNE1 through a contact hole penetrating a lower insulating layer (e.g., the second insulating layer IL2).

The third insulating layer IL3 may be disposed on the second capacitor electrode CPE2 and the second and third connection electrodes CNE2 and CNE3, and may cover the second capacitor electrode CPE2 and the second and third connection electrodes CNE2 and CNE3. The third insulating layer IL3 may include an inorganic insulating material. The third insulating layer IL3 may have a single-layer structure or a multilayer structure including a plurality of insulating layers.

The third capacitor electrode CPE3 and the fourth connection electrode CNE4 may be disposed on the third insulating layer IL3. The third capacitor electrode CPE3 and the fourth connection electrode CNE4 may include a conductive material. Each of the third capacitor electrode CPE3 and the fourth connection electrode CNE4 may have a single-layer structure or a multilayer structure including a plurality of conductive layers.

The fourth connection electrode CNE4 may be connected to the third connection electrode CNE3 through a contact hole penetrating a lower insulating layer (e.g., the third insulating layer IL3).

The fourth insulating layer IL4 may be disposed on the third capacitor electrode CPE3 and the fourth connection electrode CNE4, and may cover the third capacitor electrode CPE3 and the fourth connection electrode CNE4. The fourth insulating layer IL4 may include an inorganic insulating material. The fourth insulating layer IL4 may have a single-layer structure or a multilayer structure including a plurality of insulating layers.

The fourth capacitor electrode CPE4 may be disposed on the fourth insulating layer IL4. The fourth capacitor electrode CPE4 may include a conductive material. The fourth capacitor electrode CPE4 may have a single-layer structure or a multilayer structure including a plurality of conductive layers.

The fourth capacitor electrode CPE4 may at least partially overlap the third capacitor electrode CPE3 in a plan view. At least a portion of the fourth capacitor electrode CPE4 may overlap the third capacitor electrode CPE3 in a plan view. In an embodiment, the third capacitor electrode CPE3 and the portion of the fourth capacitor electrode CPE4 overlapping the third capacitor electrode CPE3 in a plan view may define a first sub-capacitor C2_1. In an embodiment, the third capacitor electrode CPE3 may be a first electrode of the first sub-capacitor C2_1, and the fourth capacitor electrode CPE4 may be a second electrode of the first sub-capacitor C2_1, for example. In an embodiment, the first sub-capacitor C2_1 may be a portion of the second capacitor C2.

The fifth insulating layer IL5 may be disposed on the fourth capacitor electrode CPE4, and may cover the fourth capacitor electrode CPE4. The fifth insulating layer IL5 may include an inorganic insulating material. The fifth insulating layer IL5 may have a single-layer structure or a multilayer structure including a plurality of insulating layers.

The fifth capacitor electrode CPE5 and the fifth connection electrode CNE5 may be disposed on the fifth insulating layer IL5. The fifth capacitor electrode CPE5 and the fifth connection electrode CNE5 may include a conductive material. Each of the fifth capacitor electrode CPE5 and the fifth connection electrode CNE5 may have a single-layer structure or a multilayer structure including a plurality of conductive layers.

The fifth capacitor electrode CPE5 may at least partially overlap the fourth capacitor electrode CPE4 in a plan view. At least a portion of the fifth capacitor electrode CPE5 may overlap the fourth capacitor electrode CPE4 in a plan view. In an embodiment, the fourth capacitor electrode CPE4 and the portion of the fifth capacitor electrode CPE5 overlapping the fourth capacitor electrode CPE4 in a plan view may define a second sub-capacitor C2_2. In an embodiment, the fourth capacitor electrode CPE4 may be a first electrode of the second sub-capacitor C2_2, and the fifth capacitor electrode CPE5 may be a second electrode of the second sub-capacitor C2_2, for example. In an embodiment, the second sub-capacitor C2_2 may be a portion of the second capacitor C2.

In an embodiment, the second sub-capacitor C2_2 may at least partially overlap the first sub-capacitor C2_1 in a plan view. In an embodiment, the first sub-capacitor C2_1 and the second sub-capacitor C2_2 may be arranged in the third direction DR3, for example.

In an embodiment, the second capacitor C2 may include the first sub-capacitor C2_1 and the second sub-capacitor C2_2. The second capacitor C2 may have a multi-capacitor structure (e.g., a dual-capacitor structure), and the first and second sub-capacitors C2_1 and C2_2 may function as a single capacitor. The first and second sub-capacitors C2_1 and C2_2 may be defined in different layers, and may overlap each other in a plan view. Accordingly, a capacitance of the second capacitor C2 may be secured even within a limited area.

The fifth connection electrode CNE5 may be connected to the second drain area D2 of the second active pattern AP2 through a contact hole penetrating a lower insulating layer (e.g., the first, second, third, fourth, and fifth insulating layers IL1, IL2, IL3, IL4, and IL5). In addition, the fifth connection electrode CNE5 may be connected to the third connection electrode CNE3 through a contact hole penetrating a lower insulating layer (e.g., the third, fourth, and fifth insulating layers IL3, IL4, and IL5).

The sixth insulating layer IL6 may be disposed on the fifth capacitor electrode CPE5 and the fifth connection electrode CNE5, and may cover the fifth capacitor electrode CPE5 and the fifth connection electrode CNE5. The sixth insulating layer IL6 may include an organic insulating material such as phenol resin, acrylic resin, polyimide resin, polyamide resin, siloxane resin, epoxy resin, or the like. The sixth insulating layer IL6 may have a single-layer structure or a multilayer structure including a plurality of insulating layers.

The first electrode E1 may be disposed on the sixth insulating layer IL6. The first electrode E1 may include a conductive material. In an embodiment, the first electrode E1 may be the first electrode (e.g., an anode) of the light-emitting element LE, for example.

The first electrode E1 may be connected to the fifth connection electrode CNE5 through a contact hole penetrating a lower insulating layer (e.g., the sixth insulating layer IL6). The first electrode E1 may be connected to the second drain area D2 of the second active pattern AP2 (i.e., the second electrode of the second transistor T2) through the fifth connection electrode CNE5. Accordingly, the light-emitting element LE and the pixel circuit PC of FIG. 3 may be electrically connected.

The pixel defining layer PDL may be disposed on the sixth insulating layer IL6 and the first electrode E1. The pixel defining layer PDL may cover an edge portion of the first electrode E1, and may define an opening exposing at least a portion of an upper surface of the first electrode E1. The pixel defining layer PDL may include an inorganic insulating material and/or an organic insulating material.

The light-emitting layer EL may be disposed on the first electrode E1. The light-emitting layer EL may be disposed on the first electrode E1 exposed by the opening of the pixel defining layer PDL. The light-emitting layer EL may include a light-emitting material that emits light of a selected color.

The second electrode E2 may be disposed on the light-emitting layer EL and the pixel defining layer PDL. The second electrode E2 may include a conductive material. In an embodiment, the second electrode E2 may be the second electrode (e.g., a cathode) of the light-emitting element LE, for example.

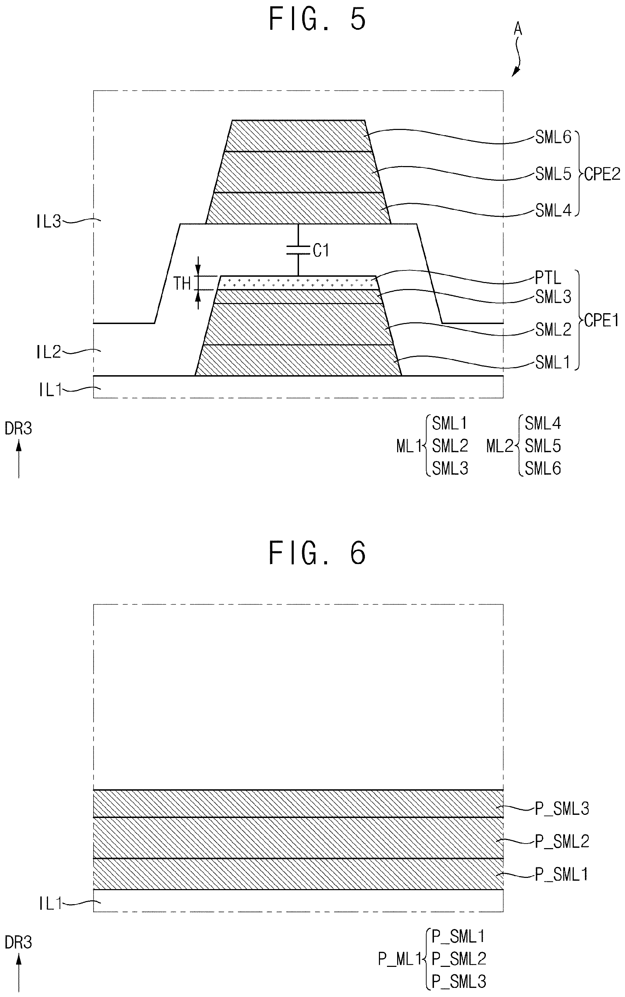

FIG. 5 is an enlarged cross-sectional view of area A in FIG. 4. FIG. 5 may be an enlarged view illustrating the first capacitor electrode CPE1 and the second capacitor electrode CPE2 defining the first capacitor C1.

Referring to FIG. 5, the second capacitor electrode CPE2 may be disposed on the first capacitor electrode CPE1, and the second insulating layer IL2 may be disposed between the first capacitor electrode CPE1 and the second capacitor electrode CPE2 in a cross-sectional view.

The first capacitor electrode CPE1 may have a multilayer structure in which a plurality of layers are stacked. The first capacitor electrode CPE1 may include a first conductive layer ML1 and a plasma-treated layer PTL.

The first conductive layer ML1 may include a first sub-conductive layer SML1, a second sub-conductive layer SML2, and a third sub-conductive layer SML3. The second sub-conductive layer SML2 may be disposed on an upper surface of the first sub-conductive layer SML1, and the third sub-conductive layer SML3 may be disposed on an upper surface of the second sub-conductive layer SML2.

The first conductive layer ML1 may include a conductive material. In an embodiment, the second sub-conductive layer SML2 may include a material (e.g., a conductive material) different from each of the first sub-conductive layer SML1 and the third sub-conductive layer SML3. In an embodiment, each of the first sub-conductive layer SML1 and the third sub-conductive layer SML3 may include titanium (Ti), and the second sub-conductive layer SML2 may include aluminum (Al), for example. However, the disclosure is not limited thereto, and the first, second, and third sub-conductive layers SML1, SML2, and SML3 may include the same material, or at least one of the first, second, and third sub-conductive layers SML1, SML2, and SML3 may include a different material, for example.

The plasma-treated layer PTL may be disposed on the first conductive layer ML1. In an embodiment, the first, second, and third sub-conductive layers SML1, SML2, and SML3 and the plasma-treated layer PTL may be sequentially disposed along the third direction DR3 on the first insulating layer IL1, for example. The plasma-treated layer PTL may be disposed on an upper surface of the third sub-conductive layer SML3. In an embodiment, the plasma-treated layer PTL may substantially cover the entirety of the upper surface of the third sub-conductive layer SML3.

The plasma-treated layer PTL may include an inorganic insulating material. The plasma-treated layer PTL may be an insulating layer. The plasma-treated layer PTL may include a high-k material. In an embodiment, the high-k material may refer to a dielectric material having a dielectric constant higher than that of silicon oxide (SiOₓ) or silicon nitride (SiNₓ), for example. A dielectric constant (or permittivity) of the plasma-treated layer PTL may be greater than a dielectric constant (or permittivity) of the second insulating layer IL2.

In an embodiment, the plasma-treated layer PTL may include titanium oxide (TiOₓ). In an embodiment, the plasma-treated layer PTL may include titanium dioxide (TiO₂), titanium(III) oxide (Ti₂O₃), or the like, for example. In an embodiment, the dielectric constant of the plasma-treated layer PTL may be about 10 to about 100, for example, but the disclosure is not limited thereto.

The plasma-treated layer PTL may be formed by plasma-treating an upper surface of the first conductive layer ML1 (i.e., the upper surface of the third sub-conductive layer SML3). In an embodiment, the upper surface of the third sub-conductive layer SML3 may be treated with oxygen plasma, and the plasma-treated layer PTL may be formed by oxidizing the upper surface of the third sub-conductive layer SML3. That is, the plasma-treated layer PTL may be different from an oxide film (i.e., a naturally oxidized film) that may be formed by naturally oxidizing the upper surface of the first conductive layer ML1.

A thickness TH of the plasma-treated layer PTL may be greater than a thickness of the oxide film that may be formed by naturally oxidizing the upper surface of the first conductive layer ML1. Here, the thickness TH of the plasma-treated layer PTL may refer to a length in a thickness direction (e.g., the third direction DR3) of the plasma-treated layer PTL. In an embodiment, a minimum value of the thickness TH of the plasma-treated layer PTL may be a thickness of an oxide film that may be formed by naturally oxidizing the upper surface of the third sub-conductive layer SML3, and a maximum value of the thickness TH of the plasma-treated layer PTL may be a thickness of the third sub-conductive layer SML3 before the plasma-treated layer PTL is formed. In an embodiment, the thickness TH of the plasma-treated layer PTL may be about 50 angstroms (Å) to about 700 Å, for example. However, the disclosure is not limited thereto, and the thickness TH of the plasma-treated layer PTL may vary depending on conditions (e.g., exposure time, power, or the like) of a plasma treatment process to form the plasma-treated layer PTL, a capacitance of the first capacitor C1, a thickness of the first capacitor electrode CPE1, or the like.

The second insulating layer IL2 may cover the first capacitor electrode CPE1, and the second capacitor electrode CPE2 may be disposed on the second insulating layer IL2. The first capacitor electrode CPE1 and the second capacitor electrode CPE2 may at least partially overlap each other in a plan view. In an embodiment, the first capacitor electrode CPE1 and the second capacitor electrode CPE2 may be disposed along the third direction DR3, for example.

The second capacitor electrode CPE2 may have a multilayer structure in which a plurality of layers are stacked. The second capacitor electrode CPE2 may include a second conductive layer ML2.

The second conductive layer ML2 may include a fourth sub-conductive layer SML4, a fifth sub-conductive layer SML5, and a sixth sub-conductive layer SML6. The fifth sub-conductive layer SML5 may be disposed on an upper surface of the fourth sub-conductive layer SML4, and the sixth sub-conductive layer SML6 may be disposed on an upper surface of the fifth sub-conductive layer SML5. In an embodiment, the fourth, fifth, and sixth sub-conductive layers SML4, SML5, and SML6 may be sequentially disposed along the third direction DR3 on the second insulating layer IL2, for example.

The second conductive layer ML2 may include a conductive material. In an embodiment, the fifth sub-conductive layer SML5 may include a material (e.g., a conductive material) different from each of the fourth sub-conductive layer SML4 and the sixth sub-conductive layer SML6. In an embodiment, each of the fourth sub-conductive layer SML4 and the sixth sub-conductive layer SML6 may include titanium (Ti), and the fifth sub-conductive layer SML5 may include aluminum (Al). However, the disclosure is not limited thereto, and the fourth, fifth, and sixth sub-conductive layers SML4, SML5, and SML6 may include the same material, or at least one of the fourth, fifth, and sixth sub-conductive layers SML4, SML5, and SML6 may include a different material.

The first capacitor electrode CPE1 and the second capacitor electrode CPE2 overlapping each other in a plan view may define the first capacitor C1. Since the first capacitor electrode CPE1 includes the plasma-treated layer PTL having a high dielectric constant, a dielectric constant of a dielectric layer between the two electrodes may increase, so that the first capacitor C1 with increased capacitance may be defined. Accordingly, the capacitance of the first capacitor C1 may be secured even within a limited area. The capacitance of the first capacitor C1 may be further increased without increasing an area in which the first and second capacitor electrodes CPE1 and CPE2 overlap in a plan view, or without reducing a thickness of the dielectric layer between the two electrodes (e.g., a thickness of the second insulating layer IL2 between the first and second capacitor electrodes CPE1 and CPE2).

Although FIG. 5 illustrates that the first capacitor C1 includes the plasma-treated layer PTL, the disclosure is not limited thereto, and the plasma-treated layer PTL may be applied to various electrodes defining a capacitor requiring secured capacitance. In an embodiment, the third capacitor electrode CPE3 or the fourth capacitor electrode CPE4 of FIG. 4 may include the plasma-treated layer PTL, for example.

The display device DD in an embodiment of the disclosure may include the first capacitor C1 defined by the first capacitor electrode CPE1 including the plasma-treated layer PTL and the second capacitor electrode CPE2. As the plasma-treated layer PTL includes a high dielectric constant (or high-k) material, the capacitance of the first capacitor C1 may be secured. Accordingly, the display device DD including the first capacitor C1 with improved capacitance characteristics may be implemented.

FIGS. 6, 7, and 8 are cross-sectional views illustrating an embodiment of a method of manufacturing a display device according to the disclosure.

The method of manufacturing the display device described with reference to FIGS. 6, 7, and 8 may be a method of manufacturing the display device DD described with reference to FIGS. 1, 2, 3, 4, and 5. The cross-sectional views of FIGS. 6, 7, and 8 may correspond to the cross-sectional view of FIG. 5. Hereinafter, redundant descriptions will be omitted or simplified.

Referring to FIG. 6, a preliminary first conductive layer P_ML1 may be formed on the first insulating layer IL1.

The preliminary first conductive layer P_ML1 may have a multilayer structure in which a plurality of layers are stacked. The preliminary first conductive layer P_ML1 may include a preliminary first sub-conductive layer P_SML1, a preliminary second sub-conductive layer P_SML2, and a preliminary third sub-conductive layer P_SML3. The preliminary second sub-conductive layer P_SML2 may be formed on an upper surface of the preliminary first sub-conductive layer P_SML1, and the preliminary third sub-conductive layer P_SML3 may be formed on an upper surface of the preliminary second sub-conductive layer P_SML2. In an embodiment, the preliminary first sub-conductive layer P_SML1, the preliminary second sub-conductive layer P_SML2, and the preliminary third sub-conductive layer P_SML3 may be sequentially disposed on the first insulating layer IL1 along the third direction DR3, for example. In an embodiment, the preliminary first sub-conductive layer P_SML1, the preliminary second sub-conductive layer P_SML2, and the preliminary third sub-conductive layer P_SML3 may be formed through a sputtering process, for example.

The preliminary first conductive layer P_ML1 may include a conductive material. In an embodiment, the preliminary second sub-conductive layer P_SML2 may include a material (e.g., a conductive material) different from each of the preliminary first sub-conductive layer P_SML1 and the preliminary third sub-conductive layer P_SML3. In an embodiment, each of the preliminary first sub-conductive layer P_SML1 and the preliminary third sub-conductive layer P_SML3 may include titanium, and the preliminary second sub-conductive layer P_SML2 may include aluminum.

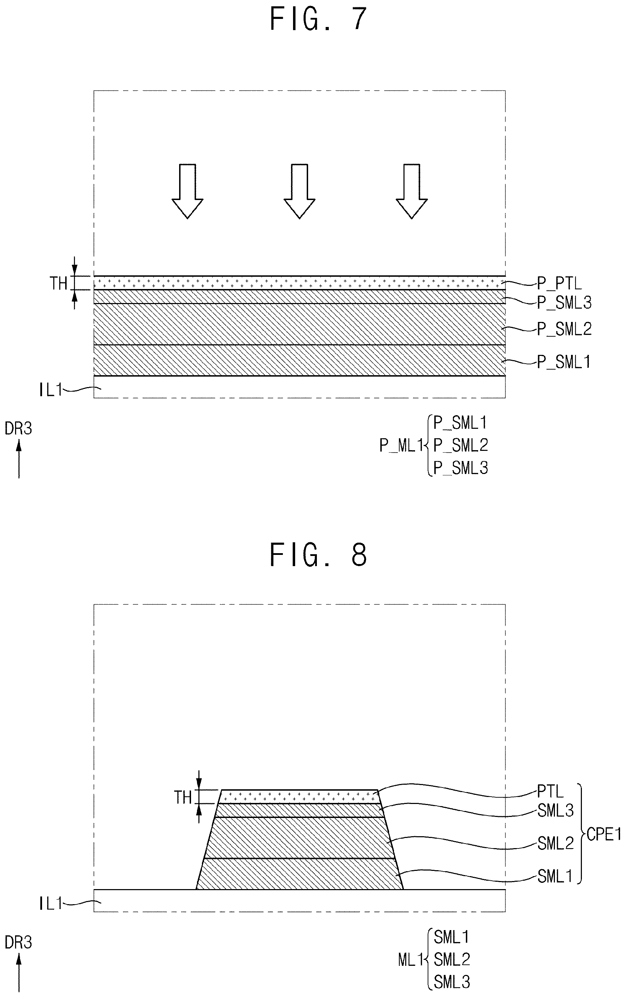

Referring further to FIG. 7, an upper surface of the preliminary first conductive layer P_ML1 may be plasma-treated. An upper surface of the preliminary third sub-conductive layer P_SML3 may be plasma-treated, and a preliminary plasma-treated layer P_PTL may be formed on the upper surface of the preliminary third sub-conductive layer P_SML3.

In an embodiment, the preliminary first conductive layer P_ML1 (i.e., the preliminary third sub-conductive layer P_SML3) may be plasma-treated through an oxygen (O₂) plasma process. In an embodiment, a display device formed up to the preliminary first conductive layer P_ML1 may be provided inside a vacuum chamber, and oxygen plasma may be injected into the vacuum chamber through a plasma generator to plasma-treat the upper surface of the preliminary third sub-conductive layer P_SML3, for example. The upper surface of the preliminary third sub-conductive layer P_SML3 may be oxidized through the oxygen plasma process to form the preliminary plasma-treated layer P_PTL.

The preliminary plasma-treated layer P_PTL may be an insulating layer, and may include a high dielectric constant (or high-k) material. In an embodiment, the preliminary third sub-conductive layer P_SML3 may include titanium, and the preliminary plasma-treated layer P_PTL may include titanium oxide. In an embodiment, the preliminary plasma-treated layer P_PTL may include titanium dioxide, titanium (III) oxide, or the like, for example.

The preliminary plasma-treated layer P_PTL may be formed with the thickness TH. The thickness TH may be a length in a thickness direction (i.e., in the third direction DR3) of the preliminary plasma-treated layer P_PTL. A minimum value of the thickness TH of the preliminary plasma-treated layer P_PTL may be a thickness of an oxide film that may be formed by naturally oxidizing the upper surface of the preliminary third sub-conductive layer P_SML3 in which the preliminary plasma-treated layer P_PTL is not formed (e.g., the preliminary third sub-conductive layer P_SML3 of FIG. 6), and a maximum value of the thickness TH of the preliminary plasma-treated layer P_PTL may be a thickness of the preliminary third sub-conductive layer P_SML3 before the preliminary plasma-treated layer P_PTL is formed (e.g., the preliminary third sub-conductive layer P_SML3 of FIG. 6). The thickness TH of the preliminary plasma-treated layer P_PTL may be adjusted by controlling conditions of the plasma treatment process (e.g., an exposure time of the upper surface of the preliminary first conductive layer P_ML1, power of the plasma, or the like).

Referring further to FIG. 8, the preliminary first conductive layer P_ML1 and the preliminary plasma-treated layer P_PTL may be patterned to form the first conductive layer ML1 and the plasma-treated layer PTL. Accordingly, the first capacitor electrode CPE1 including the first, second, and third sub-conductive layers SML1, SML2, and SML3 and the plasma-treated layer PTL may be formed on the first insulating layer IL1.

Referring back to FIG. 5, the second insulating layer IL2 may be formed on the first capacitor electrode CPE1. The second insulating layer IL2 may cover the first capacitor electrode CPE1.

The second capacitor electrode CPE2 may be formed on the second insulating layer IL2. The second capacitor electrode CPE2 may be formed to overlap at least a portion of the first capacitor electrode CPE1 in a plan view. The first capacitor electrode CPE1 and the second capacitor electrode CPE2 overlapping in a plan view may define the first capacitor C1. Accordingly, the display device DD illustrated in FIG. 5 may be manufactured.

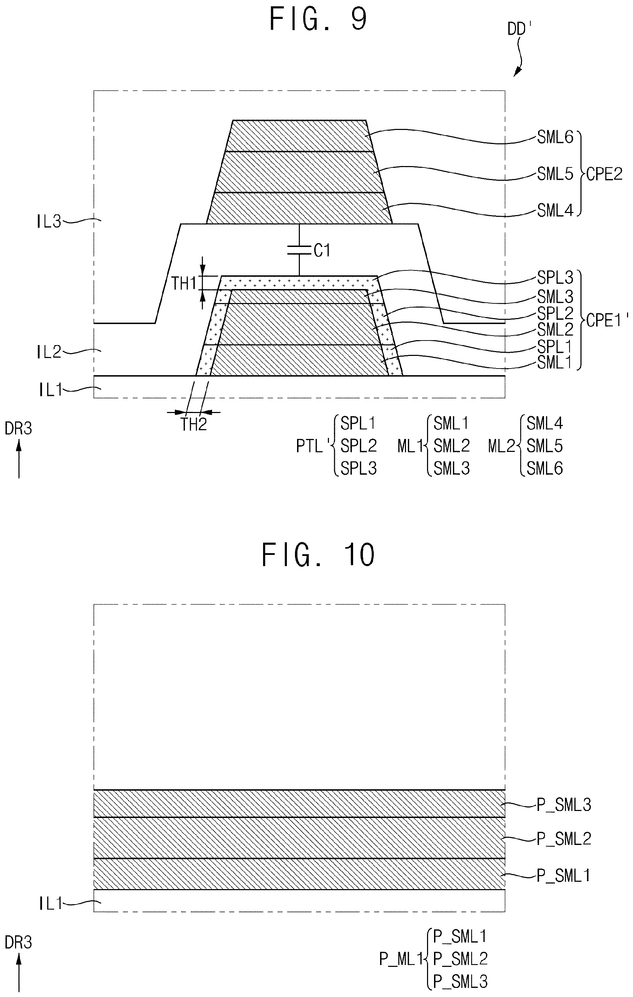

FIG. 9 is a cross-sectional view illustrating an embodiment of a display device according to the disclosure.

A display device DD' described with reference to FIG. 9 may be substantially the same as or similar to the display device DD described with reference to FIGS. 1, 2, 3, 4, and 5, except for a first capacitor electrode CPE1'. The cross-sectional view of FIG. 9 may correspond to the cross-sectional view of FIG. 5. That is, FIG. 9 may be an enlarged view of the first capacitor electrode CPE1' and a second capacitor electrode CPE2 defining a first capacitor C1. Hereinafter, redundant descriptions will be omitted or simplified.

Referring to FIG. 9, the display device DD' may include a first insulating layer IL1, the first capacitor electrode CPE1', a second insulating layer IL2, the second capacitor electrode CPE2, and a third insulating layer IL3.

The first capacitor electrode CPE1' may be disposed on the first insulating layer IL1. The first capacitor electrode CPE1' may include a first conductive layer ML1 and a plasma-treated layer PTL'. The first conductive layer ML1 may include a first sub-conductive layer SML1, a second sub-conductive layer SML2 disposed on the first sub-conductive layer SML1, and a third sub-conductive layer SML3 disposed on the second sub-conductive layer SML2.

The first conductive layer ML1 may include a conductive material. In an embodiment, each of the first sub-conductive layer SML1 and the third sub-conductive layer SML3 may include titanium, and the second sub-conductive layer SML2 may include aluminum.

The plasma-treated layer PTL' may be disposed on the first conductive layer ML1. The plasma-treated layer PTL' may be disposed on a side surface of the first sub-conductive layer SML1, a side surface of the second sub-conductive layer SML2, and a side surface and an upper surface of the third sub-conductive layer SML3. The plasma-treated layer PTL' may substantially cover a side surface and an upper surface of the first conductive layer ML1.

The plasma-treated layer PTL' may include a first sub-plasma-treated layer SPL1, a second sub-plasma-treated layer SPL2, and a third sub-plasma-treated layer SPL3. The first sub-plasma-treated layer SPL1 may cover the side surface of the first sub-conductive layer SML1, the second sub-plasma-treated layer SPL2 may cover the side surface of the second sub-conductive layer SML2, and the third sub-plasma-treated layer SPL3 may cover the side surface and the upper surface of the third sub-conductive layer SML3.

The plasma-treated layer PTL' may include an inorganic insulating material, and may be an insulating layer. The plasma-treated layer PTL' may include a high dielectric constant (or high-k) material. A dielectric constant (or permittivity) of each of the first, second, and third sub-plasma-treated layers SPL1, SPL2, and SPL3 may be greater than a dielectric constant (or permittivity) of the second insulating layer IL2. In an embodiment, each of the first and third sub-plasma-treated layers SPL1 and SPL3 may include titanium oxide, and the second sub-plasma-treated layer SPL2 may include aluminum oxide. In an embodiment, the dielectric constant of each of the first, second, and third sub-plasma-treated layers SPL1, SPL2, and SPL3 may be about 8 to about 100, for example, but the disclosure is not limited thereto.

The plasma-treated layer PTL' may be formed by plasma-treating the side surface and the upper surface of the first conductive layer ML1. In an embodiment, the side surface of the first sub-conductive layer SML1 may be treated with oxygen plasma, and the first sub-plasma-treated layer SPL1 may be formed by oxidizing the side surface of the first sub-conductive layer SML1. The side surface of the second sub-conductive layer SML2 may be treated with oxygen plasma, and the second sub-plasma-treated layer SPL2 may be formed by oxidizing the side surface of the second sub-conductive layer SML2. The side surface and the upper surface of the third sub-conductive layer SML3 may be treated with oxygen plasma, and the third sub-plasma-treated layer SPL3 may be formed by oxidizing the side surface and the upper surface of the third sub-conductive layer SML3. That is, the plasma-treated layer PTL' may be different from an oxide film that may be formed by naturally oxidizing the side surface and the upper surface of the first conductive layer ML1.

A first thickness TH1 of the plasma-treated layer PTL' may be greater than a thickness of an oxide film that may be formed by naturally oxidizing the upper surface of the first conductive layer ML1, and a second thickness TH2 of the plasma-treated layer PTL' may be greater than a thickness of an oxide film that may be formed by naturally oxidizing the side surface of the first conductive layer ML1. Here, the first thickness TH1 of the plasma-treated layer PTL' may be a length in a thickness direction of the plasma-treated layer PTL' formed on the upper surface of the first conductive layer ML1, and the second thickness TH2 of the plasma-treated layer PTL' may be a length in a width direction, e.g., in a direction (e.g., a horizontal direction in FIG. 9) parallel to a main plane extension direction of the substrate SUB (refer to FIG. 4), of the plasma-treated layer PTL' formed on the side surface of the first conductive layer ML1. In an embodiment, the first thickness TH1 of the plasma-treated layer PTL' may be about 50 Å to about 700 Å, and the second thickness TH2 of the plasma-treated layer PTL' may be greater than or equal to about 50 Å, for example, but the disclosure is not limited thereto.

The second insulating layer IL2 may be disposed on the first capacitor electrode CPE1, and may cover the first capacitor electrode CPE1.

The second capacitor electrode CPE2 may be disposed on the second insulating layer IL2, and may at least partially overlap the first capacitor electrode CPE1 in a plan view. The second capacitor electrode CPE2 may include a second conductive layer ML2. The second conductive layer ML2 may include a fourth sub-conductive layer SML4, a fifth sub-conductive layer SML5 disposed on the fourth sub-conductive layer SML4, and a sixth sub-conductive layer SML6 disposed on the fifth sub-conductive layer SML5.

The second conductive layer ML2 may include a conductive material. In an embodiment, each of the fourth sub-conductive layer SML4 and the sixth sub-conductive layer SML6 may include titanium, and the fifth sub-conductive layer SML5 may include aluminum.

The first capacitor electrode CPE1' and the second capacitor electrode CPE2 overlapping each other in a plan view may define the first capacitor C1. Since the first capacitor electrode CPE1' includes the plasma-treated layer PTL' having a high dielectric constant, a dielectric constant of a dielectric layer between the two electrodes may increase, so that the first capacitor C1 with increased capacitance may be defined. Accordingly, the capacitance of the first capacitor C1 may be secured even within a limited area. The capacitance of the first capacitor C1 may be further increased without increasing an area in which the first and second capacitor electrodes CPE1' and CPE2 overlap in a plan view, or without reducing a thickness of the dielectric layer between the two electrodes (e.g., a thickness of the second insulating layer IL2 between the first and second capacitor electrodes CPE1' and CPE2).

The third insulating layer IL3 may be disposed on the second capacitor electrode CPE2, and may cover the second capacitor electrode CPE2.

The display device DD' in an embodiment of the disclosure may include the first capacitor C1 defined by the first capacitor electrode CPE1' including the plasma-treated layer PTL' and the second capacitor electrode CPE2. Since the plasma-treated layer PTL' includes a high dielectric constant (or high-k) material, the capacitance of the first capacitor C1 may be secured. Accordingly, the display device DD' including the first capacitor C1 with improved capacitance characteristics may be implemented.

FIGS. 10, 11, and 12 are cross-sectional views illustrating an embodiment of a method of manufacturing a display device according to the disclosure.

The method of manufacturing the display device described with reference to FIGS. 10, 11, and 12 may be a method of manufacturing the display device DD' described with reference to FIG. 9. The cross-sectional views of FIGS. 10, 11, and 12 may correspond to the cross-sectional view of FIG. 9. Hereinafter, redundant descriptions will be omitted or simplified.

Referring to FIG. 10, a preliminary first conductive layer P_ML1 may be formed on the first insulating layer IL1.

The preliminary first conductive layer P_ML1 may include a preliminary first sub-conductive layer P_SML1, a preliminary second sub-conductive layer P_SML2 formed on the preliminary first sub-conductive layer P_SML1, and a preliminary third sub-conductive layer P_SML3 formed on the preliminary second sub-conductive layer P_SML2. In an embodiment, the preliminary first sub-conductive layer P_SML1, the preliminary second sub-conductive layer P_SML2, and the preliminary third sub-conductive layer P_SML3 may be formed through a sputtering process, for example.

The preliminary first conductive layer P_ML1 may include a conductive material. In an embodiment, each of the preliminary first sub-conductive layer P_SML1 and the preliminary third sub-conductive layer P_SML3 may include titanium, and the preliminary second sub-conductive layer P_SML2 may include aluminum.

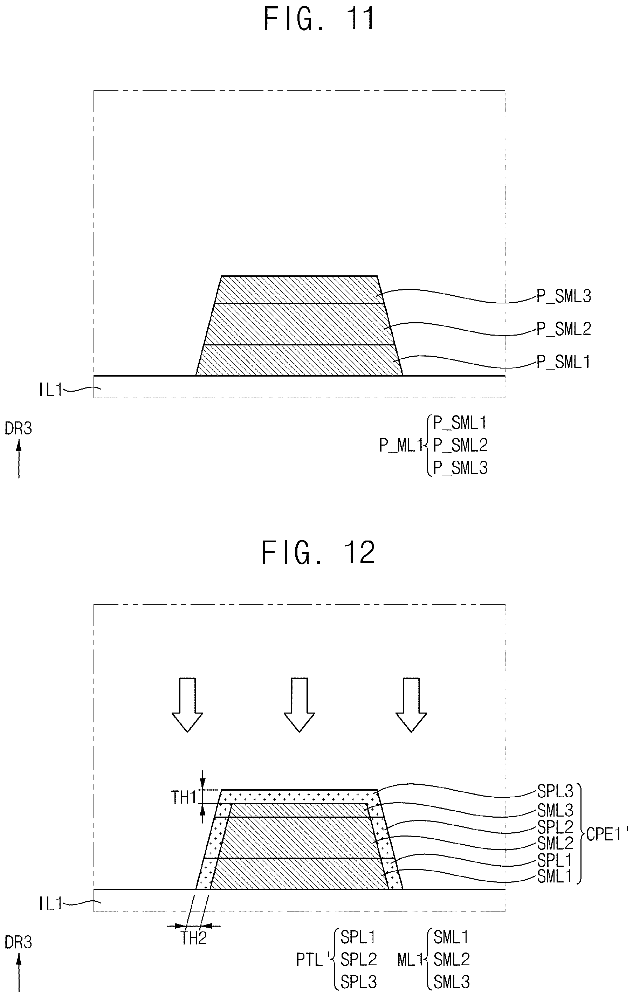

Referring further to FIG. 11, the preliminary first conductive layer P_ML1 may be patterned. In an embodiment, the preliminary first conductive layer P_ML1 may be patterned in a shape substantially the same as or similar to the first capacitor electrode CPE1' of FIG. 9, for example.

Referring further to FIG. 12, a side surface and an upper surface of the preliminary first conductive layer P_ML1 may be plasma-treated to form the first capacitor electrode CPE1' including the first conductive layer ML1 and the plasma-treated layer PTL' disposed on the first conductive layer ML1.

A side surface of the preliminary first sub-conductive layer P_SML1 may be plasma-treated, and the plasma-treated layer PTL' may be formed on the side surface of the preliminary first sub-conductive layer P_SML1, so that the first sub-conductive layer SML1 and the first sub-plasma-treated layer SPL1 covering the side surface of the first sub-conductive layer SML1 may be formed. A side surface of the preliminary second sub-conductive layer P_SML2 may be plasma-treated, and the plasma-treated layer PTL' may be formed on the side surface of the preliminary second sub-conductive layer P_SML2, so that the second sub-conductive layer SML2 and the second sub-plasma-treated layer SPL2 covering the side surface of the second sub-conductive layer SML2 may be formed. A side surface and an upper surface of the preliminary third sub-conductive layer P_SML3 may be plasma-treated, and the plasma-treated layer PTL' may be formed on the side surface and the upper surface of the preliminary third sub-conductive layer P_SML3, so that the third sub-conductive layer SML3 and the third sub-plasma-treated layer SPL3 covering the side surface and the upper surface of the third sub-conductive layer SML3 may be formed.

In an embodiment, the preliminary first conductive layer P_ML1 may be plasma-treated through an oxygen plasma process. The surfaces of the preliminary first sub-conductive layer P_SML1, the preliminary second sub-conductive layer P_SML2, and the preliminary third sub-conductive layer P_SML3 may be oxidized through the oxygen plasma process to form the plasma-treated layer PTL'. The first thickness TH1 and the second thickness TH2 of the plasma-treated layer PTL' may be adjusted by controlling conditions of the plasma treatment process (e.g., an exposure time of the surface of the preliminary first conductive layer P_ML1, power of the plasma, or the like).

Referring back to FIG. 9, the second insulating layer IL2 and the second capacitor electrode CPE2 may be sequentially formed on the first capacitor electrode CPE1'.

The second capacitor electrode CPE2 may be formed to overlap at least a portion of the first capacitor electrode CPE1' in a plan view, and the first capacitor electrode CPE1' and the second capacitor electrode CPE2 overlapping in a plan view may define the first capacitor C1. Accordingly, the display device DD' illustrated in FIG. 9 may be manufactured.

The display device DD and DD' in embodiments of the disclosure may be applied to various electronic devices. An electronic device in an embodiment of the disclosure may include the display device described above, and may further include a module or device having other additional functions in addition to the display device.

FIG. 13 is a block diagram illustrating an embodiment of an electronic device according to the disclosure.

Referring to FIG. 13, an electronic device 10 may include a display module 11, a processor 12, a memory 13, and a power module 14.

The processor 12 may include at least one of a central processing unit ("CPU"), an application processor ("AP"), a graphic processing unit ("GPU"), a communication processor ("CP"), and an image signal processor ("ISP"). The processor 12 may provide a control signal (e.g., the control signal CTRL of FIG. 2) and input image data (e.g., the input image data IDAT of FIG. 2) to a controller (e.g., the controller CON of FIG. 2) of the display module 11.

The memory 13 may store data information desired for operation of the processor 12 or the display module 11. When the processor 12 executes an application stored in the memory 13, an input image data signal and/or a control signal may be transmitted to the display module 11, and the display module 11 may process the received signal and output image information through a display screen.

The power module 14 may include a power supply module, such as a power adapter or a battery device, and a power conversion module that converts power supplied by the power supply module to generate power desired for operation of the electronic device 10.

At least one of components of the electronic device 10 may be included in the display device in embodiments of the disclosure described above. In addition, some of individual modules functionally included in one module may be included in the display device, and other portions may be provided separately from the display device. In an embodiment, the display device may include the display module 11, and the processor 12, the memory 13, and the power module 14 may be provided in form of other devices within the electronic device 10 other than the display device, for example.

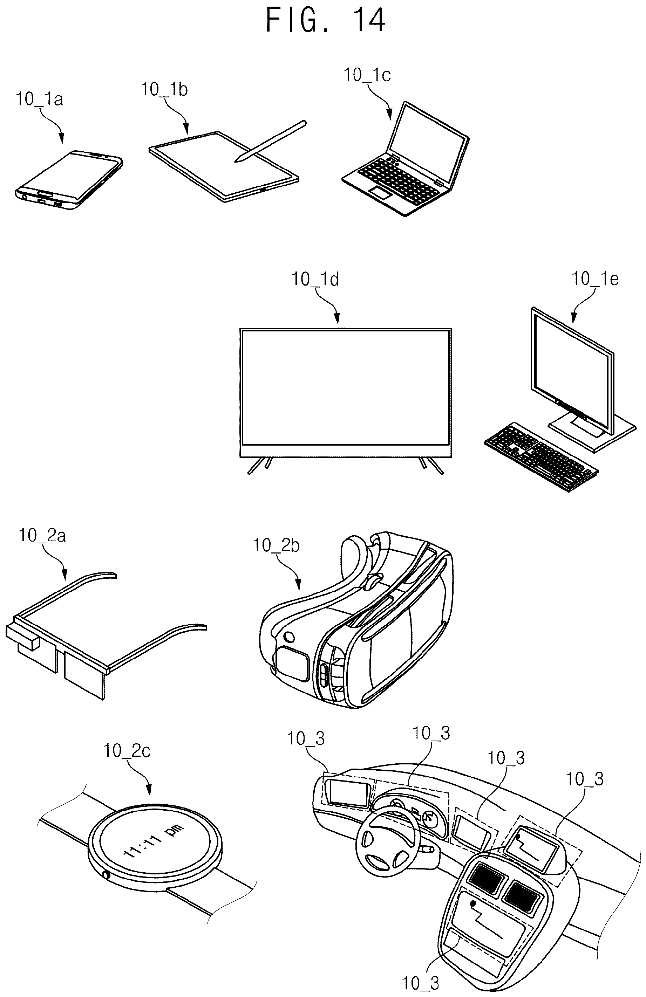

FIG. 14 is a schematic view illustrating an embodiment of electronic devices according to the disclosure.

Referring to FIG. 14, various electronic devices to which the display device in an embodiment of the disclosure is applied may include not only image display electronic devices such as a smartphone 10_1a, a tablet personal computer 10_1b, a laptop 10_1c, a television ("TV") 10_1d, and a desktop monitor 10_1e, but also wearable electronic devices including display modules, such as smart glasses 10_2a, a head-mounted display 10_2b, and a smart watch 10_2c, automotive electronic devices 10_3 including display modules, such as a Center Information Display ("CID") arranged on a cluster, a center fascia, and dashboard of a car, and a room mirror display, or the like.

The disclosure may be applied to various display devices and electronic devices. For example, the disclosure is applicable to various display devices such as display devices for vehicles, ships and aircraft, portable communication devices, display devices for exhibition or information transmission, medical display devices, or the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the inventive concept. Accordingly, all such modifications are intended to be included within the scope of the inventive concept as defined in the claims. Therefore, it is to be understood that the foregoing is illustrative of various embodiments and is not to be construed as limited to the illustrative embodiments disclosed, and that modifications to the disclosed embodiments, as well as other embodiments, are intended to be included within the scope of the appended claims.

## Claims

1. A display device (DD) comprising:
a transistor (T1);
a capacitor (C1) electrically connected to the transistor (T1), the capacitor (C1) including:
a first capacitor electrode (CPE1) including a first conductive layer (ML1) and a plasma-treated layer (PTL) disposed on the first conductive layer (ML1); and
a second capacitor electrode (CPE2) disposed on the first capacitor electrode (CPE1) and including a second conductive layer (ML2); and
an insulating layer (IL2) disposed between the first capacitor electrode (CPE1) and the second capacitor electrode (CPE2).

2. The display device (DD) of claim 1, wherein:
the plasma-treated layer (PTL) is disposed between the first conductive layer (ML1) and the second conductive layer (ML2), and
a dielectric constant of the plasma-treated layer (PTL) is greater than a dielectric constant of the insulating layer (IL2).

3. The display device (DD) of claim 1 or 2, wherein the plasma-treated layer (PTL) includes titanium oxide, and/or wherein the plasma-treated layer (PTL) is an insulating layer.

4. The display device (DD) of any one of claims 1 to 3, wherein the plasma-treated layer (PTL) covers a side surface and/or an upper surface of the first conductive layer (ML1).

5. The display device (DD) of claim 4, wherein:
the first conductive layer (ML1) includes:
a first sub-conductive layer (SML1);
a second sub-conductive layer (SML2) disposed on the first sub-conductive layer (SML1) and including a material different from a material of the first sub-conductive layer (SML1); and
a third sub-conductive layer (SML3) disposed on the second sub-conductive layer (SML2) and including a material different from the material of the second sub-conductive layer (SML2), and
the plasma-treated layer (PTL) includes:
a first sub-plasma-treated layer (SPL1) covering a side surface of the first sub-conductive layer (SML1);
a second sub-plasma-treated layer (SPL2) covering a side surface of the second sub-conductive layer (SML2); and
a third sub-plasma-treated layer (SPL3) covering a side surface of the third sub-conductive layer (SML3) and an upper surface of the third sub-conductive layer (SML3).

6. The display device (DD) of claim 5, wherein:
each of the first sub-plasma-treated layer (SPL1) and the third sub-plasma-treated layer (SPL3) includes titanium oxide, and
the second sub-plasma-treated layer (SPL2) includes aluminum oxide.

7. The display device (DD) of any one of claims 1 to 6, wherein a thickness (TH) of the plasma-treated layer (PTL) along a thickness direction is in a range of 50 angstroms to 700 angstroms, and/or wherein a dielectric constant of the plasma-treated layer (PTL) is in a range of 10 to 100.

8. A method of manufacturing a display device (DD), the method comprising:
forming a first capacitor electrode (CPE1) including a first conductive layer (ML1) and a plasma-treated layer (PTL) disposed on the first conductive layer (ML1);
forming an insulating layer (IL2) on the first capacitor electrode (CPE1);
forming a second capacitor electrode (CPE2) on the insulating layer (IL2), the second capacitor electrode (CPE2) including a second conductive layer (ML2) and defining a capacitor (C1) with the first capacitor electrode (CPE1); and
forming a transistor (T1) electrically connected to the capacitor (C1).

9. The method of claim 8, wherein in the forming the first capacitor electrode (CPE1), the plasma-treated layer (PTL) is formed by oxidizing at least a portion of a preliminary first conductive layer (P_ML1) by treating the preliminary first conductive layer (P_ML1) with oxygen plasma.

10. The method of claim 8 or 9, wherein:
the plasma-treated layer (PTL) is disposed between the first conductive layer (ML1) and the second conductive layer (ML2), and
a dielectric constant of the plasma-treated layer (PTL) is greater than a dielectric constant of the insulating layer (IL2).

11. The method of any one of claims 8 to 10, wherein the forming the first capacitor electrode (CPE1) includes:
forming a preliminary first conductive layer (P_ML1);
plasma-treating an upper surface of the preliminary first conductive layer (P_ML1) to form a preliminary plasma-treated layer (P_PTL); and
patterning the preliminary first conductive layer (P_ML1) and the preliminary plasma-treated layer (P_PTL) to form the first conductive layer (ML1) and the plasma-treated layer (PTL), or the forming the first capacitor electrode (CPE1) includes:
forming a preliminary first conductive layer (P_ML1);
patterning the preliminary first conductive layer (P_ML1); and
plasma-treating a side surface and an upper surface of the preliminary first conductive layer (P_ML1) to form the first conductive layer (ML1) and the plasma-treated layer (PTL).

12. The method of any one of claims 8 to 11, wherein the plasma-treated layer (PTL) covers an upper surface of the first conductive layer (ML1), and/or wherein the plasma-treated layer (PTL) includes titanium oxide.

13. The method of any one of claims 8 to 12, wherein the plasma-treated layer (PTL) includes:
a first sub-plasma-treated layer (SPL1) covering a side surface of the first conductive layer (ML1); and
a second sub-plasma-treated layer (SPL2) covering an upper surface of the first conductive layer (ML1) and including a material different from a material of the first sub-plasma-treated layer (SPL1).

14. The method of claim 13, wherein:
the first sub-plasma-treated layer (SPL1) includes aluminum oxide, and
the second sub-plasma-treated layer (SPL2) includes titanium oxide.

15. An electronic device (10) comprising:
a display device (DD) including:
a transistor (T1);
a capacitor (C1) electrically connected to the transistor (T1), the capacitor (C1) including:
a first capacitor electrode (CPE1) including a first conductive layer (ML1) and a plasma-treated layer (PTL) disposed on the first conductive layer (ML1); and
a second capacitor electrode (CPE2) disposed on the first capacitor electrode (CPE1) and including a second conductive layer (ML2); and
an insulating layer (IL2) disposed between the first capacitor electrode (CPE1) and the second capacitor electrode (CPE2); and
a processor (12) which provides a control signal and input image data to the display device (DD).
